(19) Europäisches Patentamt
European Patent Office
Office européen des brevets

(11) **EP 3 701 428 B1**

(12) **EUROPÄISCHE PATENTSCHRIFT**

(45) Veröffentlichungstag und Bekanntmachung des Hinweises auf die Patenterteilung:
**06.12.2023** **Patentblatt 2023/49**

(21) Anmeldenummer: **18786765.0**

(22) Anmeldetag: **15.10.2018**

(51) Internationale Patentklassifikation (IPC):
**G06N 3/045** *(2023.01)* **G06N 3/084** *(2023.01)*

(52) Gemeinsame Patentklassifikation (CPC):
**G06N 3/084; G06N 3/045**

(86) Internationale Anmeldenummer:
**PCT/EP2018/078005**

(87) Internationale Veröffentlichungsnummer:
**WO 2019/081243 (02.05.2019 Gazette 2019/18)**

(54) **VERFAHREN UND VORRICHTUNG ZUM VERBESSERN DER ROBUSTHEIT EINES MASCHINELLEN LERNSYSTEMS**

METHOD AND APPARATUS FOR IMPROVING THE ROBUSTNESS OF A MACHINE LEARNING SYSTEM

PROCÉDÉ ET DISPOSITIF DESTINÉS À AMÉLIORER LA ROBUSTESSE D'UN SYSTÈME D'APPRENTISSAGE PAR MACHINE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.10.2017 DE 102017219274**

(43) Veröffentlichungstag der Anmeldung:
**02.09.2020 Patentblatt 2020/36**

(73) Patentinhaber: **Robert Bosch GmbH**
**70442 Stuttgart (DE)**

(72) Erfinder: **METZEN, Jan Hendrik**
**71034 Boeblingen (DE)**

(56) Entgegenhaltungen:
**DE-U1-202017 102 381**

• **Jan Hendrik Metzen ET AL: "On Detecting Adversarial Perturbations", , 21. Februar 2017 (2017-02-21), Seiten 1-12, XP055539598, arXiv.org Gefunden im Internet: URL:https://arxiv.org/abs/1702.04267 [gefunden am 2019-01-09]**
• **Sandy Huang ET AL: "Adversarial Attacks on Neural Network Policies", , 8. Februar 2017 (2017-02-08), Seiten 1-10, XP055539606, arXiv.org Gefunden im Internet: URL:https://arxiv.org/abs/1702.02284 [gefunden am 2019-01-09]**

**Beschreibung**

Die Erfindung betrifft ein computerimplementiertes Verfahren zum Betreiben eines Detektors, ein Computerprogramm das Anweisungen umfasst, welche eingerichtet sind, das Verfahren auszuführen, wenn es auf einem Computer ausgeführt wird, ein maschinenlesbares Speichermedium, auf dem das Computerprogramm gespeichert ist und einen Computer, der eingerichtet ist, das Verfahren auszuführen.

Stand der Technik

Aus der DE 20 2017 102 381 ist eine Vorrichtung zum Generieren eines manipulierten Datensignals zum Täuschen eines ersten maschinellen Lernsystems bekannt, welches eingerichtet ist, eine semantische Segmentierung eines empfangenen ein- oder mehrdimensionalen Datensignals zu ermitteln, wobei die Vorrichtung ein maschinenlesbares Speichermedium umfasst, auf dem Befehle gespeichert sind, die beim Ausführen durch einen Computer bewirken, dass der Computer ein Verfahren mit den folgenden Schritten ausführt:

a) Ermitteln gewünschten semantischen Segmentierung des manipulierten Datensignals; und
b) Generieren des manipulierten Datensignals abhängig vom empfangenen Datensignal (und der ermittelten gewünschten semantischen Segmentierung sowie einer geschätzten semantischen Segmentierung des manipulierten Datensignals.

Die Autoren Metzen, J. H., Genewein, T., Fischer, V., & Bischoff, B. schlagen in ihrer Veröffentlichung "On detecting adversarial perturbations", arXiv preprint arXiv:1702.04267,online zugänglich https://arxiv.org/pdf/1702.04267.pdf, vor, tiefe neuronale Netze um ein kleines "Detektor"-Teilnetz zu erweitern, das auf die binäre Klassifikationsaufgabe der Unterscheidung zwischen echten Daten und Daten enthaltend böswilligen Störungen trainiert ist.

Vorteil der Erfindung

Das Verfahren mit den Merkmalen des unabhängigen Anspruch 1 hat demgegenüber dem Vorteil, dass es ermöglicht, ein Ausgangssignal eines maschineller Lernsystems besonders robust gegenüber kontradiktorischen Beispielen (Englisch: *adversarial examples*) zu machen. Adversarial Examples sind geringfügig manipulierte Eingangsdaten (die bei Bilddaten den unmanipulierten Eingangsdaten so ähnlich sind, dass sie für menschliche Experten praktisch nicht zu unterscheiden sind), die zu einer erheblichen Änderung führen können. Beispielsweise wäre es denkbar, dass ein bösartiger Angreifer ein solches kontradiktorisches Beispiel einsetzt, um einen autonomen Roboter in die Irre zu leiten, indem er beispielsweise eine semantische Segmentierung, die einen tatsächlich vorhanden Fluss als "Fluss" markiert, unterdrückt, was zu einer Gefährdung des autonomen Roboters, der seine Routenplanung basierend auf dieser semantischen Segmentierung durchführt, führen könnte. Mit dem erfindungsgemäßen Verfahren kann die Wirksamkeit solcher Angriffe reduziert werden.

Vorteilhafte Weiterbildungen sind Gegenstand der unabhängigen Ansprüche.

Offenbarung der Erfindung

In einem ersten Aspekt betrifft die Erfindung ein Verfahren zum Betreiben eines Detektors, der eingerichtet ist, zu prüfen, ob ein Datensignal, welches einem maschinellen Lernsystem zugeführt wird, ein manipuliertes Datensignal ist, also manipuliert wurde, und somit möglicherweise zu einem fehlerhaften Ausgangssignal des maschinellen Lernsystems führen wird, wobei das maschinelle Lernsystem zunächst mittels eines manipulierten Datensignals kontradiktorisch trainiert wurde. Der Begriff "kontradiktorisches Training" ist im Englischen geläufig unter der Bezeichnung *adversarial training.*

Hierbei wird das manipulierte Datensignal durch Manipulation eines Trainingsdatensignals ermittelt, und das maschinelle Lernsystem beim kontradiktorischen Training darauf trainiert, jeweils das gleiche Ausgangssignal zu liefern, unabhängig davon, ob ihm das Trainingsdatensignal oder das manipulierte Datensignal zugeführt wird.

Dann wird der Detektor mittels eines weiteren manipulierten Datensignals trainiert, welches abhängig vom trainierten maschinellen Lernsystem erzeugt wird.

D.h. der Detektor wird darauf trainiert, zu entscheiden, dass das ihm zugeführte Datensignal ein manipuliertes Datensignal ist, also manipuliert wurde, wenn ihm ein weiteres manipuliertes Datensignal zugeführt wird und darauf zu entscheiden, dass dies nicht der Fall sein wird, wenn das ihm zugeführte Datensignal kein weiteres manipuliertes Datensignal ist.

Dies hat den Vorteil, dass der Detektor besonders robust wird, da der der Raum der möglichen weiteren manipulierten Datensignale kleiner ist als der Raum der manipulierten Datensignale. Ein so trainierter Detektor ist damit insbesondere besonders gut einsetzbar, um zu detektieren, dass es sich bei den Eingangssignalen um kontradiktorische Beispiele handelt.

Dass derartige kontradiktorische Beispiele vorkommen, ist eine Eigenschaft zahlreicher maschineller Lernsysteme, sofern der Raum ihrer Eingangsgrößen hochdimensional ist. Bei dem maschinellen Lernsystem kann es sich entsprechend um ein tiefes neuronales Netzwerk handeln, oder eine (Multiklassen-) logistische Regression, um einen k-nächste-Nachbarn-Algorithmus, oder eine Support Vector Machine.

Insbesondere kann vorgesehen sein, dass das manipulierte Datensignal abhängig von einem Gradienten einer vom Eingangssignal abhängigen Kostenfunktion des maschinellen Lernsystems gewählt wird, der in Richtung eines gewünschten Ausgangssignals zeigt. Auf diese Weise lassen sich besonders einfach manipulierte Datensignale generieren, die trotz sehr großer Ähnlichkeit zum unmanipulierten Datensignal zu einem unterschiedlichen Ausgangssignal, insbesondere eines unterschiedlichen Klassifikationsergebnisses, des maschinellen Lernsystems führen.

Vorzugsweise wird das manipulierte Datensignal derart erzeugt, dass seine Differenz zum Datensignal einen Term beinhaltet, der in Gegenrichtung dieses Gradienten zeigt.

Alternativ oder zusätzlich kann vorgesehen sein, dass das weitere manipulierte Datensignal abhängig von einem zweiten Gradienten einer vom Eingangssignal abhängigen Kostenfunktion des kontradiktorisch trainierten maschinellen Lernsystems gewählt wird, der in Richtung eines gewünschten Ausgangssignals zeigt. Auf diese Weise lassen sich besonders einfach weitere manipulierte Datensignale generieren, die trotz sehr großer Ähnlichkeit zum unmanipulierten Datensignal zu einem unterschiedlichen Ausgangssignal, insbesondere eines unterschiedlichen Klassifikationsergebnisses, des maschinellen Lernsystems führen.

Vorzugsweise wird das weitere manipulierte Datensignal derart erzeugt, dass seine Differenz zum Datensignal einen Term beinhaltet, der in Gegenrichtung dieses zweiten Gradienten zeigt.

In einem weiteren Aspekt der Erfindung kann vorgesehen sein, dass der Detektor prüft ob ein Datensignal, welches dem maschinellen Lernsystem zugeführt wird, zu einem fehlerhaften Ausgangssignal des maschinellen Lernsystems führen wird.

Dies kann insbesondere benutzt werden, um eine Ansteuerung eines Agenten, insbesondere eines Aktors wie beispielsweise eines wenigstens teilautonomen Roboters, abhängig vom ermittelten Ausgangssignal und von einem Prüfergebnis des Detektors zu gestalten. Auf diese Weise wird die Ansteuerung besonders robust gegenüber Attacken mit kontradiktorischen Beispielen.

In weiteren Aspekten betrifft die Erfindung ein Computerprogramm das eingerichtet ist, das erfindungsgemäße Verfahren auszuführen. D.h. das Computerprogramm umfasst Anweisungen, die einen Computer veranlassen, das erfindungsgemäße Verfahren auszuführen, wenn die er das Computerprogramm abspielt.

In noch weiteren Aspekten betrifft die Erfindung ein maschinenlesbares Speichermedium, auf dem dieses Computerprogramm gespeichert ist, und einen Computer, der eingerichtet ist, das Verfahren auszuführen.

Nachfolgend werden Ausführungsformen der Erfindung unter Bezugnahme auf die beiliegenden Zeichnungen näher erläutert. In den Zeichnungen zeigen:

Figur 1    schematisch eine Einsatzmöglichkeit eines erfindungsgemäßen Detektors;

Figur 2    in einem Flussdiagramm einen möglichen Ablauf eines Trainingsverfahrens des Detektors.

Beschreibung der Ausführungsbeispiele

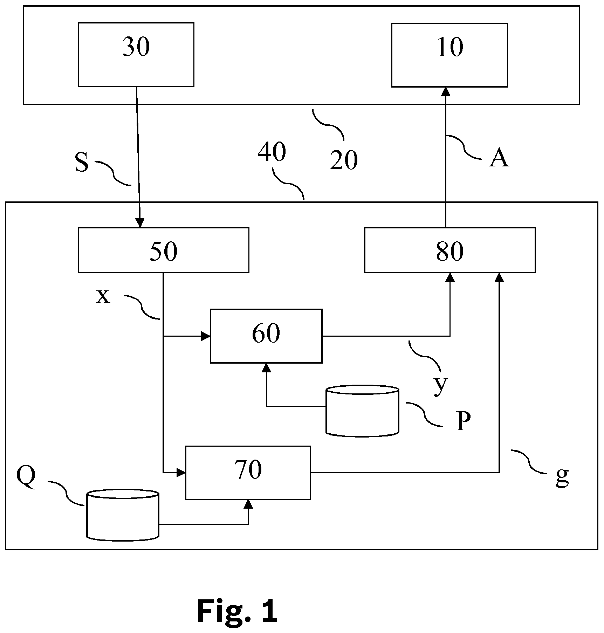

Figur 1 zeigt beispielhaft einen Aktor 10 in seiner Umgebung 20 in Interaktion mit einem Aktorsteuerungssystem 40. Aktor 10 und Umgebung 20 werden gemeinschaftlich nachfolgend auch als Aktorsystem bezeichnet. Ein Zustand des Aktorsystems wird mit einem Sensor 30 erfasst, der auch durch eine Mehrzahl von Sensoren gegeben sein kann. Ein Ausgangssignal S des Sensors 30 wird an das Aktorsteuerungssystem 40 übermittelt. Das Aktorsteuerungssystem 40 ermittelt hieraus ein Ansteuersignal A, welches der Aktor 10 empfängt.

Bei dem Aktor 10 kann es sich beispielsweise um einen (teil-)autonomen Roboter, beispielsweise ein (teil-)autonomes Kraftfahrzeug handeln. Bei dem Sensor 30 kann es sich beispielsweise um einen oder mehrere Videosensoren und/oder einen oder mehrere Radarsensoren und/oder einen oder mehrere Ultraschallsensoren und/oder einen oder mehrere Positionssensoren (beispielsweise GPS) handeln. Alternativ oder zusätzlich kann der Sensor 30 auch ein Informationssystem umfassen, das eine Information über einen Zustand des Aktorsystems ermittelt, wie beispielsweise ein Wetterinformationssystem, das einen aktuellen oder zukünftigen Zustand des Wetters in der Umgebung 20 ermittelt.

In einem anderen Ausführungsbeispiel kann es sich bei dem Aktor 10 um einen Fertigungsroboter handeln, und bei dem Sensor 30 dann beispielsweise um einen optischen Sensor handeln, der Eigenschaften von Fertigungserzeugnissen des Fertigungsroboters erfasst.

In einem weiteren Ausführungsbeispiel kann es sich bei dem Aktor 10 um ein Freigabesystem handeln, welches eingerichtet ist, die Aktivität eines Geräts freizugeben oder nicht. Bei dem Sensor 30 kann es sich beispielsweise um einen optischen Sensor (beispielsweise zur Erfassung von Bild- oder Videodaten) handeln, der eingerichtet ist, ein Gesicht zu erfassen. Der Aktor 10 ermittelt abhängig vom Ansteuersignal A ein Freigabesignal, das benutzt werden kann, um abhängig vom Wert des Freigabesignals das Gerät freizugeben. Bei dem Gerät kann es sich beispielsweise um eine physische oder logische Zugangskontrolle handeln. Abhängig vom Wert des Ansteuersignals A kann die Zugangskontrolle dann vorsehen, dass Zugang gewährt wird, oder nicht.

Es ist auch möglich, dass an Stelle des Aktors 10 beispielsweise ein medizinisches Diagnosesystem angesteuert wird, welches abhängig von dem Ansteuersignal A eine medizinische Diagnose ausgibt. Wenn es sich bei dem Sensor 30 um einen optischen Sensor handelt, der medizinische Bilder erfasst kann es sich bei dem Ansteuersignal A beispielsweise um eine ggf. mit Anmerkungen versehene semantische Segmentierung der Bilder handeln, in denen Bereiche, die für eine medizinische Diagnose als besonders relevant erscheinen, hervorgehoben sind. In diesem Fall bezeichnet das Bezugszeichen 40 ein Agentensteuerungssystem.

Das Aktorsteuerungssystem 40 empfängt das Ausgangssignal S des Sensors in einer optionalen Empfangseinheit 50, die das Ausgangssignal S in ein Datensignal x umwandelt (alternativ kann auch unmittelbar das Ausgangssignal S als Datensignal x übernommen werden). Das Datensignal x kann beispielsweise ein Ausschnitt oder eine Weiterverarbeitung des Ausgangssignals S sein. Das Ausgangssignal x wird einem maschinellen Lernsystem 60, beispielsweise einem neuronalen Netzwerk, zugeführt. Das maschinelle Lernsystem 60 wird durch Parameter charakterisiert, die in einem Parameterspeicher P abgespeichert sind.

Das Datensignal x ist ein zweidimensionales Bildsignal, dessen Pixel durch z.B. einen (Helligkeitskodierung) oder drei Zahlenwerte (RGB-Kodierung) charakterisiert sind. Das Datensignal x kann aber auch, gemäß nicht beanspruchten Ausführungsbeispielen, ein anderes ein- oder mehrdimensionales Datensignal sein.

Das maschinelle Lernsystem 60 ermittelt aus dem Bildsignal x ein zugehöriges Ausgangssignal y, beispielsweise eine pixelweise semantische Segmentierung. Hierbei wird jedem Bereich des Bildsignals x ein semantischer Wert zugeordnet.

Das Aktorsteuerungssystem 40 umfasst ferner einen Detektor 70, beispielsweise ein neuronales Netzwerk. Der Detektor 70 empfängt ebenfalls das Bildsignal x und ermittelt hieraus ein Detektorsignal g, das beispielsweise eine Zahl im Wertebereich [0;1] sein kann und eine Wahrscheinlichkeit charakterisieren kann, dass das Bildsignal x derart manipuliert wurde, dass die semantische Segmentierung y die Bilddaten x nicht korrekt charakterisiert. Der Detektor wird durch Parameter charakterisiert, die in einem zweiten Parameterspeicher Q gespeichert sind.

Im Ausführungsbeispiel wird dies dadurch erreicht, dass der Detektor 70 derart eingerichtet ist, dass das Detektorsignal g eine Wahrscheinlichkeit charakterisiert, dass es sich bei dem Bildsignal x um ein kontradiktorisches Beispiel handelt.

Semantische Segmentierung y und Detektorsignal g werden einer Ausgabeeinheit 80 übermittelt, die hieraus das Ansteuersignal A ermittelt. Beispielsweise ist es möglich, dass die Ausgabeeinheit zunächst überprüft, ob das Detektorsignal g kleiner ist als ein vorgebbarer Schwellenwert. Ist dies der Fall, wird abhängig von der semantischen Segmentierung y das Ansteuersignal A ermittelt. Dies ist der Normalfall. Wird hingegen ermittelt, dass das Detektorsignal g nicht kleiner ist als der vorgebbare Schwellenwert, so kann vorgesehen sein, dass das Ansteuersignal A derart ausgebildet ist, dass es den Aktor A in einen abgesicherten Modus überführt. Dies ist der Fall, wenn der Detektor 70 im Bildsignal x einen Fehler detektiert.

Das Aktorsteuerungssystem 40 umfasst in einer Ausführungsform einen Computer und ein maschinenlesbares Speichermedium (nicht dargestellt), auf dem ein Computerprogramm gespeichert ist, dass, wenn es vom Computer ausgeführt wird, diesen veranlasst, die beschriebenen Funktionalitäten des Aktorsteuerungssystems 40 auszuführen. Maschinelles Lernsystem 60 und Detektor 70 können hier insbesondere als separate oder gemeinsame Computerprogramme implementiert sein.

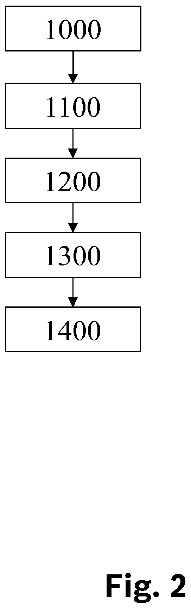

Figur 2 zeigt in einem Flussdiagramm den möglichen Ablauf eines Trainingsverfahrens des Detektors 70. Zunächst (1000) wird das maschinelle Lernsystem 60 in üblicher Weise trainiert, zu Eingangssignalen x passende Ausgangssignale y zu generieren. Dies kann beispielsweise überwacht durch einen Trainingsdatensatz erfolgen, der Eingangssignale x und hierzu jeweils zugeordnet gewünschte Ausgangssignale yt enthält. Durch Auswertung einer Kostenfunktion (Englisch: loss *function*) J zwischen generierten Ausgangssignalen y und gewünschten Ausgangssignalen yt können dann durch Rückführung (Englisch: *backpropagation*) die Parameter des maschinellen Lernsystems 60 angepasst werden. Anstelle von Schritt (1000) kann auch ein vortrainiertes maschinelles Lernsystem 60 herangezogen werden.

Dann (1100) wird ein zweiter Trainingsdatensatz ermittelt, beispielsweise aus einem Computerspeicher ausgelesen. Der zweite Trainingsdatensatz enthält Trainingssignale $x^{train}$ mit zugeordneten gewünschten Ausgangssignalen $y^{train}$. Zu diesen Trainingssignalen $x^{train}$ werden jeweils zugeordnete kontradiktorische Beispiele $x^{adv}$ generiert. Dies erfolgt beispielsweise durch iterative Anwendung der Formeln $x_0^{adv} = 0$

$$x_{n+1}^{adv} = Clip_{x,\epsilon}\left(x_n^{adv} + \alpha \cdot \text{sgn}\left(\nabla_x J(x_n^{adv}, y^{train})\right)\right). \tag{1}$$

Der Parameter $\alpha$ kann hierbei z.B. gleich 1 gewählt werden. Die Funktion $Clip_{x,\epsilon}(e)$ begrenzt ein Argument $e$ hierbei auf eine $\epsilon$-Umgebung um e, beispielsweise in einer Maximumsnorm. Ist die Iteration hierbei bei einem Index $m$ hinreichend konvergiert, wird das kontradiktorische Beispiel x$^{adv}$ gleich $x_m^{adv}$ gewählt.

Alternativ kann in Schritt (1100) auch einfach ein Satz von Trainingssignalen x$^{train}$ und zugeordneten kontradiktorischen Signalen x$^{adv}$ eingelesen werden.

Dann (1200) wird das maschinelle Lernsystem 60 kontradiktorisch trainiert, d.h. dem maschinellen Lernsystem 60 Trainingssignale x$^{train}$ und zugeordnete kontradiktorische Signale x$^{adv}$ zugeführt, und die zugehörigen Ausgangssignale y$^{true}$ (für das Trainingssignal x$^{train}$) und y$^{false}$ (für das kontradiktorische Signal x$^{adv}$) ermittelt. Die Parameter, die das maschinelle Lernsystem 60 charakterisieren, werden nun (z.B. über eine geeignete Kostenfunktion und Backpropagation) derart angepasst, dass die beiden Ausgangssignale y$^{true}$ und y$^{false}$ möglichst gleich sind.

Schritte (1100) und (1200) können auch mehrfach iteriert durchgeführt werden, z.B. derart, dass in Schritt (1100) jeweils ein Stapel kontradiktorischer Signale x$^{adv}$ generiert wird, mittels dessen dann in Schritt (1200) das maschinelle Lernsystem 60 kontradiktorisch trainiert wird. Dann kann Schritt (1100) auf Basis des so trainierten maschinellen Lernsystems 60 erneut durchgeführt werden, usw.

Anschließend (1300) wird ein dritter Trainingsdatensatz ermittelt, beispielsweise aus einem Computerspeicher ausgelesen. Auch der dritte Trainingsdatensatz enthält Trainingssignale x$^{train}$. Analog zu Schritt (1100) werden nun weitere manipulierte Datensignale x$^{adv;2}$ generiert. Es sei angemerkt, dass hierbei bei der Anwendung von Formel (1) die Kostenfunktion J von den Parametern abhängig ist, die das maschinelle Lernsystem 60 charakterisieren. Hierdurch wirkt sich das in Schritt (1200) durchgeführte kontradiktorische Training des maschinellen Lernsystems 60 auf das Generieren der weiteren manipulierten Datensignale x$^{adv;2}$ aus. Es werden zugeordnete gewünschte Ausgangssignale y$^{train}$ generiert, die beispielsweise den Wert 0 annehmen, wenn das dem Detektor 70 im nächsten Schritt (1400) zuzuführende Signal ein unmanipuliertes Trainingssignal x$^{train}$ ist und den Wert 1 annehmen, wenn das dem Detektor 70 zuzuführende Signal ein weiteres manipuliertes Datensignal x$^{adv;2}$ ist.

Dann (1400) wird der Detektor 70 mit den weiteren manipulierten Datensignale x$^{adv;2}$ und weiteren unmanipulierten Signalen x$^{train}$ darauf trainiert, dass sein Ausgabesignal g möglichst anzeigt, dass ein manipuliertes Signal vorliegt, wenn dem Detektor 70 eines der weiteren manipulierten Datensignale x$^{adv;2}$ zugeführt wird und möglichst anzeigt, dass kein manipuliertes Signal vorliegt, wenn ihm ein unmanipuliertes Signal x$^{train}$ zugeführt wird. Damit endet das Lernverfahren zum Trainieren des Detektors 70.

Das Verfahren kann als Computerprogramm also Software oder in Hardware oder einer Mischform aus Hardware und Software implementiert sein.

**Patentansprüche**

1. Computerimplementiertes Verfahren zum Betreiben eines Detektors (70), der eingerichtet ist, zu prüfen, ob ein Datensignal (x), welches einem maschinellen Lernsystem (60) zugeführt wird, manipuliert wurde,

   wobei das Datensignal (x) ein zweidimensionales Bildsignal ist,
   wobei das maschinelle Lernsystem (60) zunächst mittels einem manipulierten Datensignal (x$^{adv}$) kontradiktorisch trainiert wird, wobei das manipulierte Datensignal (x$^{adv}$) durch Manipulation eines Trainingsdatensignals (x$^{train}$) ermittelt wurde,
   wobei das Trainingsdatensignal (x$^{train}$) ein zweidimensionales Bildsignal und das manipulierte Datensignal (x$^{adv}$) ein zweidimensionales Bildsignal ist,
   und wobei das maschinelle Lernsystem (60) darauf trainiert wird, jeweils das gleiche Ausgangssignal (y) zu liefern, wenn ihm das Trainingsdatensignal (x$^{train}$) bzw. das manipulierte Datensignal (x$^{adv}$) zugeführt wird,
   wobei das Ausgangssignal (y) des maschinellen Lernsystems (60) ein Klassifikationsergebnis ist,
   wobei der Detektor (70) mittels einem weiteren manipulierten Datensignal (x$^{adv;2}$) und eines weiteren Trainingsdatensignals (x$^{train}$) darauf trainiert wird, dass sein Ausgabesignal (g) anzeigt, dass ein manipuliertes Datensignal vorliegt, wenn dem Detektor (70) das weitere manipulierte Datensignal (x$^{adv;2}$) zugeführt wird und anzeigt, dass kein manipuliertes Datensignal vorliegt, wenn dem Detektor (70) das Trainingsdatensignal (x$^{train}$) zugeführt wird,
   wobei das weitere manipulierte Datensignal (x$^{adv;2}$) aus dem weiteren Trainingsdatensignal (x$^{train}$) abhängig vom trainierten maschinellen Lernsystem (60) erzeugt wird,

wobei das weitere manipulierte Datensignal ($x^{adv;2}$) ein zweidimensionales Bildsignal und das weitere Trainingsdatensignal ($x^{train}$) ein zweidimensionales Bildsignal ist.

2. Verfahren nach Anspruch 1, wobei das maschinelle Lernsystem (60) ein neuronales Netz ist, und wobei das manipulierte Datensignal ($x^{adv}$) abhängig von einem Gradienten einer vom Eingangssignal ($x$) abhängigen Kostenfunktion des maschinellen Lernsystems (60) gewählt wird, der in Richtung eines gewünschten Ausgangssignals ($y^{target}$) zeigt.

3. Verfahren nach Anspruch 2, wobei das manipulierte Datensignal ($x^{adv}$) derart erzeugt wird, dass seine Differenz zum Datensignal ($x$) einen Term beinhaltet, der in Gegenrichtung dieses Gradienten zeigt.

4. Verfahren nach einem der Ansprüche 2 oder 3, wobei das weitere manipulierte Datensignal ($x^{adv;2}$) abhängig von einem zweiten Gradienten einer vom Eingangssignal ($x$) abhängigen Kostenfunktion des kontradiktorisch trainierten maschinellen Lernsystems (60) gewählt wird, der in Richtung eines gewünschten Ausgangssignals ($y^{target}$) zeigt.

5. Verfahren nach Anspruch 4, wobei das weitere manipulierte Datensignal ($x^{adv;2}$) derart erzeugt wird, dass seine Differenz zum Datensignal ($x$) einen Term beinhaltet, der in Gegenrichtung dieses zweiten Gradienten zeigt.

6. Verfahren nach einem der vorherigen Ansprüche, wobei der Detektor (70) prüft ob ein Datensignal ($x$), welches einem maschinellen Lernsystem (60) zugeführt wird, manipuliert wurde.

7. Verfahren nach Anspruch 6, wobei eine Ansteuerung (A) eines Agenten (10), abhängig vom ermittelten Ausgangssignal ($y$) und von einem Prüfergebnis ($g$) des Detektors (70) erfolgt.

8. Computerprogramm, umfassend Befehle, die bei der Ausführung des Computerprogramms durch einen Computer diesen veranlassen, das Verfahren nach einem der Ansprüche 1 bis 7 auszuführen.

9. Maschinenlesbares Speichermedium, auf dem das Computerprogramm nach Anspruch 8 gespeichert ist.

10. Computer, der eingerichtet ist, das Verfahren nach einem der Ansprüche 1 bis 7 auszuführen.

**Claims**

1. Computer-implemented method for operating a detector (70) that is configured to check whether a data signal ($x$) supplied to a machine learning system (60) has been manipulated,

   wherein the data signal ($x$) is a two-dimensional image signal,
   wherein the machine learning system (60) is initially contradictorily trained by means of a manipulated data signal ($x^{adv}$), the manipulated data signal ($x^{adv}$) having been ascertained by manipulating a training data signal ($x^{train}$),
   wherein the training data signal ($x^{train}$) is a two-dimensional image signal and the manipulated data signal ($x^{adv}$) is a two-dimensional image signal, and wherein the machine learning system (60) is trained to deliver the same output signal ($y$) whenever it is supplied with the training data signal ($x^{train}$) or the manipulated data signal ($x^{adv}$),
   wherein the output signal ($y$) of the machine learning system (60) is a classification result,
   wherein the detector (70) is trained by means of a further manipulated data signal ($x^{adv;2}$) and a further training data signal ($x^{train}$) so that its output signal ($g$) indicates that there is a manipulated data signal if the detector (70) is supplied with the further manipulated data signal ($x^{adv;2}$), and indicates that there is no manipulated data signal if the detector (70) is supplied with the training data signal ($x^{train}$),
   wherein the further manipulated data signal ($x^{adv;2}$) is generated from the further training data signal ($x^{train}$) on the basis of the trained machine learning system (60), wherein the further manipulated data signal ($x^{adv;2}$) is a two-dimensional image signal and the further training data signal ($x^{train}$) is a two-dimensional image signal.

2. Method according to Claim 1, wherein the machine learning system (60) is a neural network, and wherein the manipulated data signal ($x^{adv}$) is selected on the basis of a gradient of a cost function of the machine learning system (60) that is dependent on the input signal ($x$), said gradient pointing in the direction of a desired output signal ($y^{target}$).

3. Method according to Claim 2, wherein the manipulated data signal ($x^{adv}$) is generated in such a way that its difference in relation to the data signal ($x$) includes a term that points in the opposite direction from this gradient.

**4.** Method according to either of Claims 2 and 3, wherein the further manipulated data signal ($x^{adv;2}$) is selected on the basis of a second gradient of a cost function of the contradictorily trained machine learning system (60) that is dependent on the input signal (x), said gradient pointing in the direction of a desired output signal ($y^{target}$).

**5.** Method according to Claim 4, wherein the further manipulated data signal ($x^{adv;2}$) is generated in such a way that its difference in relation to the data signal (x) includes a term that points in the opposite direction from this second gradient.

**6.** Method according to one of the preceding claims, wherein the detector (70) checks whether a data signal (x) supplied to a machine learning system (60) has been manipulated.

**7.** Method according to Claim 6, wherein an agent (10) is actuated (A) on the basis of the ascertained output signal (y) and a check result (g) from the detector (70).

**8.** Computer program comprising instructions that, when the computer program is executed by a computer, cause said computer to carry out the method according to one of Claims 1 to 7.

**9.** Machine-readable storage medium on which the computer program according to Claim 8 is stored.

**10.** Computer configured to carry out the method according to one of Claims 1 to 7.


**Revendications**

**1.** Procédé mis en œuvre par ordinateur destiné à faire fonctionner un détecteur (70), qui est conçu pour vérifier si un signal de données (x), lequel est acheminé à un système d'apprentissage automatique (60), a été manipulé,

le signal de données (x) étant un signal d'image bidimensionnel,
le système d'apprentissage automatique (60) étant tout d'abord entraîné de manière contradictoire au moyen d'un signal de données manipulé ($x^{adv}$), le signal de données manipulé ($x^{adv}$) ayant été déterminé par manipulation d'un signal de données d'entraînement ($x^{train}$),
le signal de données d'entraînement ($x^{train}$) étant un signal d'image bidimensionnel et le signal de données manipulé ($x^{adv}$) étant un signal d'image bidimensionnel, et le système d'apprentissage automatique (60) étant entraîné pour délivrer à chaque fois le même signal de sortie (y) lorsque le signal de données d'entraînement ($x^{train}$) ou le signal de données manipulé ($x^{adv}$) lui est acheminé,
le signal de sortie (y) du système d'apprentissage automatique (60) étant un résultat de classification,
le détecteur (70) étant entraîné au moyen d'un signal de données manipulé supplémentaire ($x^{adv;2}$) et d'un signal de données d'entraînement supplémentaire ($x^{train}$) afin que son signal de sortie (g) indique qu'un signal de données manipulé est présent lorsque le signal de données manipulé supplémentaire ($x^{adv;2}$) est acheminé au détecteur (70) et indique qu'aucun signal de données manipulé n'est présent lorsque le signal de données d'entraînement ($x^{train}$) est acheminé au détecteur (70),
le signal de données manipulé supplémentaire ($x^{adv;2}$) étant généré à partir du signal de données d'entraînement supplémentaire ($x^{train}$) en fonction du système d'apprentissage automatique (60) entraîné,
le signal de données manipulé supplémentaire ($x^{adv;2}$) étant un signal d'image bidimensionnel et le signal de données d'entraînement supplémentaire ($x^{train}$) un signal d'image bidimensionnel.

**2.** Procédé selon la revendication 1, le système d'apprentissage automatique (60) étant un réseau neuronal et le signal de données manipulé ($x^{adv}$) étant sélectionné en fonction d'un gradient d'une fonction de coût du système d'apprentissage automatique (60), dépendant d'un signal d'entrée (x), qui pointe en direction d'un signal de sortie souhaité ($y^{target}$).

**3.** Procédé selon la revendication 2, le signal de données manipulé ($x^{adv}$) étant généré de telle sorte que sa différence par rapport au signal de données (x) contient un terme qui pointe dans la direction opposée à ce gradient.

**4.** Procédé selon l'une des revendications 2 et 3, le signal de données manipulé supplémentaire ($x^{adv;2}$) étant sélectionné en fonction d'un deuxième gradient d'une fonction de coût du système d'apprentissage automatique (60) entraîné de manière contradictoire, dépendant du signal d'entrée (x), qui pointe en direction d'un signal de sortie souhaité ($y^{target}$).

**5.** Procédé selon la revendication 4, le signal de données manipulé supplémentaire ($x^{adv;2}$) étant généré de telle sorte que sa différence par rapport au signal de données (x) contient un terme qui pointe dans la direction opposée à ce deuxième gradient.

**6.** Procédé selon l'une des revendications précédentes, le détecteur (70) vérifiant si un signal de données (x), lequel est acheminé à un système d'apprentissage automatique (60), a été manipulé.

**7.** Procédé selon la revendication 6, une commande (A) d'un agent (10) s'effectuant en fonction du signal de sortie (y) déterminé et d'un résultat de contrôle (g) du détecteur (70).

**8.** Programme informatique comprenant des instructions qui, lorsque le programme informatique est exécuté par un ordinateur, amènent celui-ci à mettre en œuvre le procédé selon l'une des revendications 1 à 7.

**9.** Support de stockage lisible par machine sur lequel est stocké le programme informatique selon la revendication 8.

**10.** Ordinateur, qui est conçu pour mettre en œuvre le procédé selon l'une des revendications 1 à 7.

**Fig. 1**

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 202017102381

**In der Beschreibung aufgeführte Nicht-Patentliteratur**

- **METZEN, J. H. ; GENEWEIN, T. ; FISCHER, V. ; BISCHOFF, B.** On detecting adversarial perturbations. *arXiv preprint arXiv:1702.04267, https://arxiv.org/pdf/1702.04267.pdf,*